# EUROPEAN PATENT APPLICATION

(11) **EP 3 009 672 A1**
(43) Date of publication of application: **20.04.2016**
(21) Application number: 15153452.6
(22) Date of filing: 02.02.2015
(51) Int. Cl.: F03D 9/46, H02S 40/10, H02S 10/12

(54) **Hybrid solar, wind and water energy segment**

(30) Priority: 14.10.2014 LT 2014119
(71) Applicant: UAB "Globalios Technoidejos", 72256 Taurage (LT)
(72) Inventor: Jokubaitis, Viktoras, 72256 Taurage (LT)
(74) Representative: Zaboliene, Reda

(57) **Abstract**

The invention relates to equipment involved in natural-source energy supply by making use of solar, wind, and water energy.

Hybrid energy segment is installed on the multifunctional communication line shaped as tunnel (5) with separated communication channels (6, 7 and 8) inside and equipped with tower-shaped (1) supports with wind driven electric plant components (2), where towers (1) have additional horizontal (3) and vertical (4) supports on which the tunnel-shaped structure (5) in mounted. Top wall (12) of the tunnel (5) is sloping and sun-facing. The top wall (12) of the tunnel (5) has rails (14) on which solar cell (13) cleaner carriage (15) moves.

Water collection gutters (23) are installed at the bottom part of the top wall (12) of the tunnel (5) and connected to water collection tank (25) installed in support tower (1) and connected to hydroelectric power station turbine (26) and lower reservoir (27).

## Description

### FIELD OF THE INVENTION

The invention relates to devices relevant to natural source energy supply by making use of solar, wind, and water energy as well as to adaptation of individual wind and other components of energy segment for special needs.

### BACKGROUND OF THE INVENTION

The use of solar, wind, and water energy as renewable energy sources is increasing all over the world. One of the most notable examples is installation of 16 thousand solar cells on the railway tunnel, which was carried out by the United States company Enfinity America Corp. in 2011 in the 2.2 mile long part of Paris-Amsterdam high-speed railway transport line. This tunnel protects trains against possible downfalls of forest trees and provides electric energy to Antwerpen railway station. The amount of energy produced each year would be enough for all Belgium trains to run for one day.

DE 19650024 (A1) presents a bridge structure where solar cells are installed on surfaces of a frame the cross-section of which is rectangular. Solar cells are placed on sun-facing lateral surfaces of the frame and (or) the planes located at the top part of the frame. Energy generated by the solar cells is used for illumination of the bridge or heating of the road surface.

DE1998102762 (A1) describes a hybrid energy segment comprising two wind power turbines installed on bridge portal masts and a solar power plant with solar cells attached to crossbar linking bridge portal masts. Furthermore, additional solar cells can be mounted on guard rails of the bridge structure.

The closest prior art is a multifunctional communication line for transportation of people, materials, information, energy, and vehicles as described in DE 10225967 (C1). The line comprises a tunnel-shaped structure with separated channels inside and hung at the desired height on mast-shaped supports. There is a hybrid solar and wind segment installed on top of this communication line and consisting of wind power plant components installed on supports and of solar cells that can be attached to top horizontal surface and sides of the tunnel.

Communication line according to the patent DE 10225967 (C1) has a series of essential drawbacks. One of them is that hanging the tunnel is complicated and unreliable because of probable vibrations. Another drawback that is particularly important in terms of the hybrid energy segment is insufficient collection of solar energy from the horizontal top surface of the tunnel resulting from inadequate use of solar radiation. One more drawback is that under weather action solar cells quickly get covered with dirt and their performance drops substantially. Cleaning them is inconvenient or impossible (for example, when the tunnel runs over buildings, mountains, water bodies etc.). Furthermore, as the hybrid energy segment described in the said patent is installed on the multifunctional communication line, it does not make use of the energy of rainwater flowing down from the surface of the tunnel.

The main aim of the invention is to create a hybrid energy segment free from the said shortcomings inherent to the communication line in accordance with DE 10225967 (C1). Another aim is to expand the functional potential of the energy segment by utilizing the energy of the accumulated water.

### SUMMARY OF THE INVENTION

The first aim of the invention is attained by that the supports of the hybrid energy segment in accordance with the general part of the claims are shaped as towers, where towers have additional horizontal and vertical supports on which the tunnel with sloping and sun-facing top wall is installed. Such mounting of tunnel on support comprising tower as well as horizontal and vertical supports facilitates attachment of the communication tunnel and makes it less susceptible to ground vibrations. By selecting optimal inclination of the top wall of the tunnel and taking sun movement trajectory into account the amounts of solar energy collected can be maximised.

The top wall of the tunnel has rails on which solar cell cleaner carriage moves, this has driven wheels and rotating brushes. The rotating brushes of the cleaner carriage enable periodical or on-demand removal of dirt accumulated on solar cells. In case of large dimensions of the top surface of the tunnel, service staircase and protective roof can be used.

When water collection gutters are installed at the bottom part of the top wall of the tunnel and connected to water collection tank installed in the support tower and connected to turbine and lower reservoir of hydropower station, the functional potential of the energy segment is upgraded to a hybrid solar, wind and water energy segment. This energy segment is capable of accumulating even greater hydroenergy potential if the lower reservoir is connected via water elevation installation to the upper reservoir connected to water collection tank.

### BRIEF DESCRIPTION OF THE DRAWINGS

The sample embodiment of the invention is described in greater detail with references to the attached drawings, where:

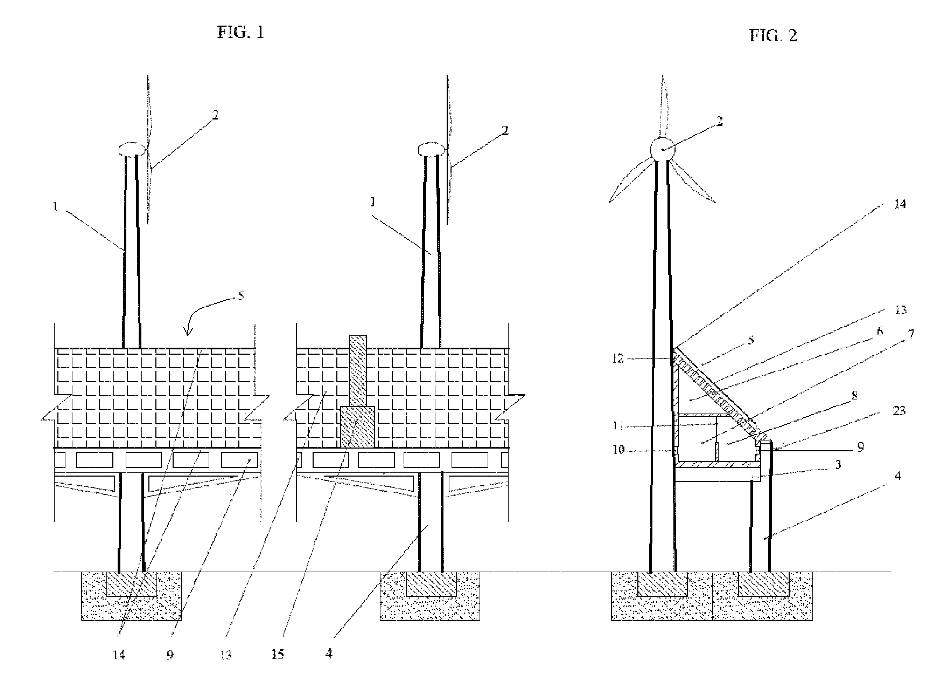

Fig. 1 shows a side view of the hybrid solar, wind and water energy segment.
Fig. 2 shows a rear view of the energy segment with a tunnel cross-section view.

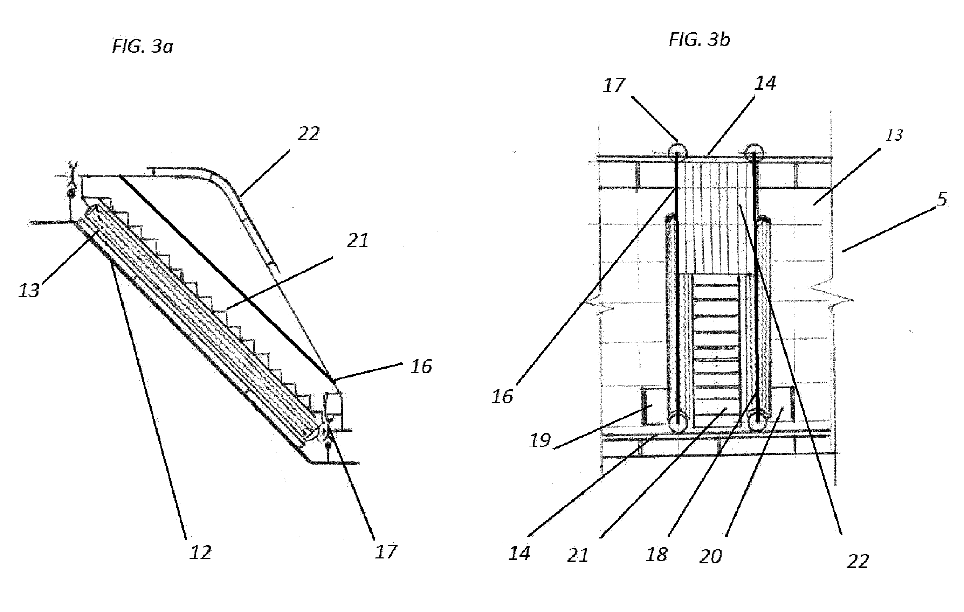

Fig. 3a shows a tunnel side view of the energy segment solar cell cleaner carriage.
Fig. 3b shows a carriage end view of the energy segment solar cell cleaner carriage.

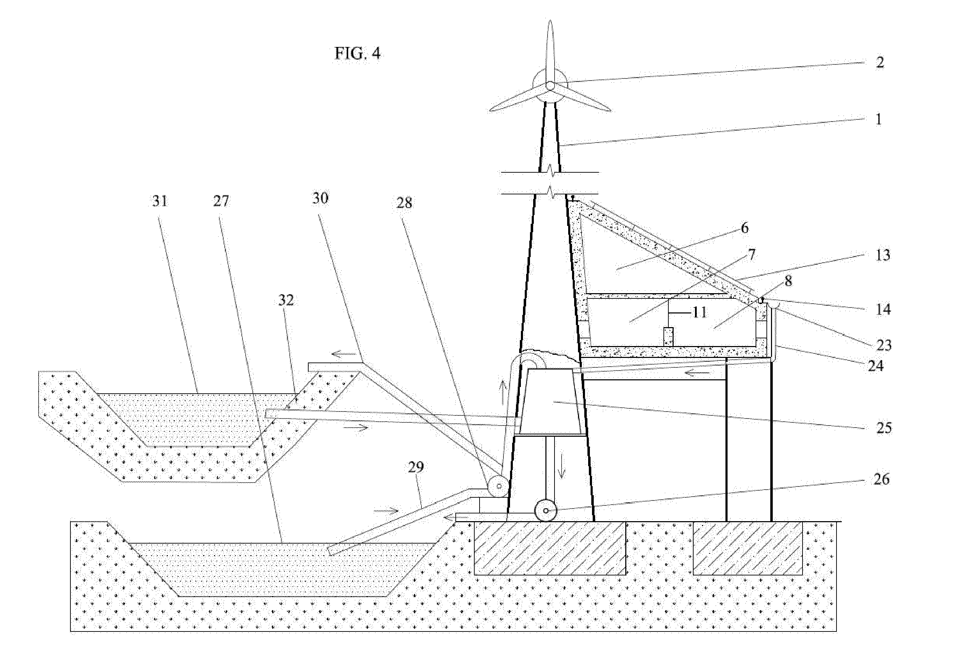

Fig. 4 shows a rear view of the hybrid energy segment with water energy part.

### DESCRIPTION OF THE PREFERRED EMBODIMENTS

Hybrid solar, wind, and water energy segment is installed between at least two towers 1 on which (depending on their structure) the required number of wind power plant components 2 is installed. Towers 1 have horizontal 3 and vertical 4 supports on which tunnel 5 in mounted, this tunnel comprises, for instance, three communication channels 6, 7 and 8, each of which may serve distinct function. For example, channel 6 can be used for bidirectional transportation of materials, products, information, and energy. Channels 7 and 8 can be used for bidirectional transportation of people on escalators, in capsules, cabins (cars), on rails, magnetic or air cushions and have windows 9 and 10 installed in outer walls and intended for enabling light to reach the inside of the tunnel 5 as well as monitoring of the environment by travellers from inside. There is a transparent divider 11 between channels 7 and 8.

Solar cells 13 are mounted on the surface of sloping top wall 12 of tunnel 5. Wall 12 is positioned against the sun so that as the sun moves solar cells 13 receive the maximum amounts of sunlight to generate the maximum amounts of electrical power. Top and bottom parts of wall 12 are where rails 14 are installed, these rails enable movement of solar cell 13 cleaner carriage 15 that comprises cleaner frame 16, driven wheels 17, rotating cleaning brushes 18, and cleaning brush and wheel drive devices 19 and 20. Carriage 15 may be equipped with service staircase 21 and protective roof 22.

At the bottom part of top wall 12 of tunnel 5, below solar cells 13, water collection gutters 23 are installed that are connected by pipes 24 to water collection tank 25 from which water is supplied to hydroelectric power station turbine 26. The used water enters the lower reservoir 27 from which, in times of surplus of electric power, water is returned via pipe 29 by pump 28 to water collection tank 25 or supplied via pipe 30 to upper reservoir 31 from which, in times of demand for electric power, water goes via pipe 32 over water collection tank 25 and to hydroelectric power station turbine 26.

## Claims

1. Hybrid energy segment, installed on multifunctional communication line shaped as tunnel (5) with separated communication channels (6, 7 and 8) inside and equipped with supports (1) on which tunnel-shaped structure (5) is mounted, where solar cells (13) are installed on tunnel surface (12) and wind driven electric plant components (2) are set-up on supports (1), **characterized in that** the supports are shaped as towers (1) and these towers (1) have additional horizontal (3) and vertical (4) supports on which the tunnel (5) is mounted and that top wall (12) of the tunnel (5) is sloping and sun-facing.

2. Energy segment according to claim 1, **characterized in that** top wall (12) of the tunnel (5) has rails (14) on which solar cell (13) cleaner carriage (15) moves.

3. Energy segment according to claim 2, **characterized in that** cleaner carriage (15) has driven wheels (17) and rotating cleaning brushes (18).

4. Energy segment according to claim, **characterized in that** cleaner carriage (15) has service staircase (21) and protective roof (22).

5. Energy segment according to claims 1-4, **characterized in that** water collection gutters (23) connected to water collection tank (25) connected to hydroelectric power station turbine (26) are installed at the bottom part of the top wall (12) of the tunnel (5).

6. Energy segment according to claim 1, **characterized in that** water collection tank (25) is installed in support tower (1).

7. Energy segment according to claims 5 or 6, **characterized in that** water collection tank (25) is connected to lower reservoir (27).

8. Hybrid solar, wind, and water energy segment according to claims 5-7.

9. Energy segment according to claim 8, **characterized in that** lower reservoir (27) is connected via water elevation installation (28) to upper reservoir (31) connected to water collection tank (25).

10. Hybrid energy segment according to any claim above, **characterized in that** the energy segment is situated between at least two towers (1).
